# EUROPÄISCHE PATENTANMELDUNG

(11) **EP 3 252 439 A2**
(43) Veröffentlichungstag der Anmeldung: **06.12.2017**
(21) Anmeldenummer: 17170779.7
(22) Anmeldetag: 12.05.2017
(51) Int. Cl.: G01F 1/716, G01F 15/02

(54) **VERFAHREN ZUM BETREIBEN EINES KERNMAGNETISCHEN DURCHFLUSSMESSGERÄTS UND KERNMAGNETISCHES DURCHFLUSSMESSGERÄT**

(30) Priorität: 31.05.2016 DE 102016109993
(71) Anmelder: Krohne AG, 4019 Basel (CH)
(72) Erfinder: Hogendoorn, Cornelis Johannes, 4211 BG Spijk (NL); Tromp, Rutger Reinout, 3311 EM Dordrecht (NL); Cerioni, Lucas Matias Ceferino, 3311 GN Dordrecht (NL); Zoeteweij, Marco Leendert, 3344 EP Hendrik-Ido-Ambach (NL); Bousché, Olaf Jean Paul, 3319 PH Dordrecht (NL)
(74) Vertreter: Gesthuysen Patent- und Rechtsanwälte

(57) **Zusammenfassung**

Dargestellt und beschrieben ist ein Verfahren zum Betreiben eines kernmagnetischen Durchflussmessgeräts (1), wobei das kernmagnetische Durchflussmessgerät (1) ein Messrohr (2) mit einer Messstrecke (6) aufweist, ein Medium (8) durch das Messrohr (2) geströmt wird und das Medium (8) im Messrohr (2) magnetisiert wird.

Der Erfindung liegt die Aufgabe zugrunde ein Verfahren anzugeben, bei dem die Abhängigkeit einer Bestimmung einer Geschwindigkeit des Mediums (8) durch das Messrohr (2) von Eigenschaften oder dem Zustand des Mediums (8) zumindest reduziert ist.

Die Aufgabe ist dadurch gelöst, dass ein mit einer ersten Geschwindigkeit strömendes erstes Volumen (10) des magnetisierten Mediums (8) innerhalb der Messstrecke (6) zu kernmagnetischen Resonanzen angeregt wird und ein erster Signalverlauf gebildet wird, indem mindestens ein die kernmagnetischen Resonanzen des Mediums (8) im ersten Volumen (10) innerhalb der Messstrecke (6) charakterisierendes Signal bestimmt wird, dass anschließend ein mit einer zweiten Geschwindigkeit strömendes zweites Volumen (11) des magnetisierten Mediums (8) innerhalb der Messstrecke (6) zu kernmagnetischen Resonanzen angeregt wird und ein zweiter Signalverlauf gebildet wird, indem mindestens ein die kernmagnetischen Resonanzen des Mediums (8) im zweiten Volumen (11) innerhalb der Messstrecke (6) charakterisierendes Signal bestimmt wird, dass ein Quotientenverlauf bestimmt wird, indem jeweils ein Quotient aus dem mindestens einen Signal des ersten Signalverlaufs und aus dem mindestens einen Signal des zweiten Signalverlaufs bestimmt wird und dass die erste Geschwindigkeit und/oder die zweite Geschwindigkeit unter Verwendung des Quotientenverlaufs bestimmt werden bzw. wird.

## Beschreibung

Die Erfindung betrifft zum einen Verfahren zum Betreiben eines kernmagnetischen Durchflussmessgeräts. Das kernmagnetische Durchflussmessgerät weist dabei zur Durchführung der Verfahren ein Messrohr mit mindestens einer ersten Messstrecke auf. Bei den Verfahren wird ein Medium durch das Messrohr geströmt und wird das Medium im Messrohr magnetisiert.

Die Erfindung betrifft zum anderen auch kernmagnetische Durchflussmessgeräte. Die kernmagnetischen Durchflussmessgeräte weisen ein Messrohr, eine Magnetisierungseinrichtung und eine Messeinrichtung auf, wobei das Messrohr mindestens eine erste Messstrecke aufweist. Im Betrieb der kernmagnetischen Durchflussmessgeräte strömt ein Medium durch das Messrohr und magnetisiert die Magnetisierungseinrichtung das Medium im Messrohr.

Ein kernmagnetisches Durchflussmessgerät nutzt zur Analyse und insbesondere zur Durchflussmessung eines Mediums durch das Messrohr kernmagnetische Resonanzmessverfahren. Kernmagnetische Resonanzmessverfahren beeinflussen die Präzession von Atomkernen eines Mediums bei Anwesenheit eines makroskopischen Magnetfelds, welches das Medium zuvor magnetisiert hat, durch Anregung der Atomkerne mittels eines auf das Medium wirkenden elektromagnetischen Pulses und werten die Wirkung der Anregung auf die Atomkerne aus. Ein kernmagnetisches Durchflussmessgerät weist deshalb zur Erzeugung eines Magnetfelds in einem durch das Messrohr strömenden Medium eine Magnetisierungseinrichtung und zur Anregung des Mediums im Messrohr und zur Messung der Wirkung der Anregung auf das Medium im Messrohr eine Messeinrichtung auf. Dabei ist die Messeinrichtung auch ausgebildet, Verfahren zum Betreiben eines kernmagnetischen Durchflussmessgeräts auszuführen.

Die Atomkerne der Elemente, die einen Kernspin besitzen, besitzen auch ein durch den Kernspin hervorgerufenes magnetisches Moment. Der Kernspin kann als ein durch einen Vektor beschreibbarer Drehimpuls aufgefasst werden und entsprechend kann auch das magnetische Moment durch einen Vektor beschrieben werden, der parallel zum Vektor des Drehimpulses ist. Der Vektor des magnetischen Moments eines Atomkerns präzessiert bei Anwesenheit eines makroskopischen Magnetfelds wie dem durch die Magnetisierungseinrichtung erzeugten um den Vektor des makroskopischen Magnetfelds an der Stelle des Atomkerns. Die Frequenz der Präzession wird als Larmorfrequenz ω_{L} bezeichnet und ist proportional zum Betrag der Magnetfeldstärke B. Die Larmorfrequenz berechnet sich gemäß ω_{L} = γ B. Darin ist γ das gyromagnetische Verhältnis, welches für Wasserstoffatomkerne maximal ist.

Kernmagnetische Durchflussmessgeräte messen den Durchfluss eines Mediums durch das Messrohr. Der Durchfluss des Mediums bezieht sich entweder auf einen Volumendurchfluss oder auf einen Massedurchfluss, wobei sowohl der Volumendurchfluss als auch der Massedurchfluss jeweils unter Verwendung einer Dichte des Mediums und einer Geschwindigkeit des Mediums im Messrohr bestimmt werden. Aus dem Stand der Technik bekannte Verfahren zum Betreiben eines kernmagnetischen Durchflussmessgeräts und bekannte kernmagnetische Durchflussmessgeräte bestimmen eine Geschwindigkeit eines Mediums im Messrohr, indem ein Volumen des magnetisierten Mediums innerhalb einer Messstrecke zu kernmagnetischen Resonanzen angeregt und ein Signalverlauf gebildet wird. Dabei wird der Signalverlauf gebildet, indem Signale bestimmt werden, die die kernmagnetischen Resonanzen des Mediums im Volumen innerhalb der Messstrecke charakterisieren. Die Signale im Signalverlauf nehmen mit zunehmender Zeit ab, wobei die Abnahme der Signale insbesondere durch zwei Faktoren beeinflusst wird. Der erste Faktor beschreibt die Abnahme der Signale mit zunehmender Zeit im Wesentlichen aufgrund von Wechselwirkungen der Kernspins der Atomkerne des Mediums. Dieser Faktor ist von Eigenschaften und dem Zustand des Mediums abhängig, wobei der Zustand insbesondere durch die Temperatur des Mediums beschrieben ist. Der zweite Faktor beschreibt die Abnahme der Signale mit zunehmender Zeit aufgrund des Herausströmens des angeregten Mediums aus der Messstrecke. Dieser Faktor enthält somit die Information über die Geschwindigkeit des Mediums, wohingegen der erste Faktor diese Information beeinträchtigt.

Eine Aufgabe der vorliegenden Erfindung ist daher die Angabe von Verfahren zum Betreiben eines kernmagnetischen Durchflussmessgeräts sowie von kernmagnetischen Durchflussmessgeräten, bei denen die Abhängigkeit einer Bestimmung einer Geschwindigkeit eines Mediums durch das Messrohr von Eigenschaften und/oder dem Zustand des Mediums zumindest reduziert ist.

Die Erfindung bezieht sich zunächst auf Verfahren zum Betreiben von kernmagnetischen Durchflussmessgeräten, bei denen die hergeleitete und aufgezeigte Aufgabe gelöst ist. Solche kernmagnetischen Durchflussmessgeräte weisen ein Messrohr mit mindestens einer ersten Messstrecke auf.

Ein erstes Verfahren zum Betreiben eines kernmagnetischen Durchflussmessgeräts mit einem Messrohr, wobei das Messrohr eine erste Messstrecke aufweist, ist gemäß einer Lehre der Erfindung zunächst und im Wesentlichen durch die folgenden Verfahrensschritte gekennzeichnet, die ausgeführt werden, wenn ein Medium durch das Messrohr geströmt wird und das Medium im Messrohr magnetisiert wird:
In einem ersten Verfahrensschritt wird ein mit einer ersten Geschwindigkeit strömendes erstes Volumen des magnetisierten Mediums innerhalb der ersten Messstrecke zu kernmagnetischen Resonanzen angeregt und wird ein erster Signalverlauf gebildet, indem mindestens ein die kernmagnetischen Resonanzen des Mediums im ersten Volumen innerhalb der ersten Messstrecke charakterisierendes Signal bestimmt wird.

In einem zweiten sich zeitlich an den vorangehenden Verfahrensschritt anschließenden Verfahrensschritt wird ein mit einer zweiten Geschwindigkeit strömendes zweites Volumen des magnetisierten Mediums innerhalb der ersten Messstrecke zu kernmagnetischen Resonanzen angeregt und wird ein zweiter Signalverlauf gebildet, indem mindestens ein die kernmagnetischen Resonanzen des Mediums im zweiten Volumen innerhalb der ersten Messstrecke charakterisierendes Signal bestimmt wird.

In einem dritten Verfahrensschritt wird ein Quotientenverlauf bestimmt, indem jeweils ein Quotient aus dem mindestens einen Signal des ersten Signalverlaufs und aus dem mindestens einen Signal des zweiten Signalverlaufs bestimmt wird.

In einem vierten Verfahrensschritt werden entweder die erste Geschwindigkeit und die zweite Geschwindigkeit unter Verwendung des Quotientenverlaufs bestimmt oder wird die erste Geschwindigkeit oder die zweite Geschwindigkeit unter Verwendung des Quotientenverlaufs bestimmt. Das Verfahren bestimmt die erste Geschwindigkeit und/oder die zweite Geschwindigkeit, wenn während der Ausführung des Verfahrens die erste Geschwindigkeit des Mediums während des ersten Verfahrensschritts und die zweite Geschwindigkeit des Mediums während des zweiten Verfahrensschritts voneinander verschieden sind.

Ein zweites Verfahren zum Betreiben eines kernmagnetischen Durchflussmessgeräts mit einem Messrohr, wobei das Messrohr eine erste Messstrecke und eine zweite Messstrecke aufweist, ist gemäß einer zur vorangehenden Lehre alternativen Lehre der Erfindung zunächst und im Wesentlichen durch die folgenden Verfahrensschritte gekennzeichnet, die ausgeführt werden, wenn ein Medium durch das Messrohr geströmt wird und das Medium im Messrohr magnetisiert wird:
In einem ersten Verfahrensschritt wird ein erstes Volumen des magnetisierten Mediums innerhalb der ersten Messstrecke zu kernmagnetischen Resonanzen angeregt und wird ein erster Signalverlauf gebildet, indem mindestens ein die kernmagnetischen Resonanzen des Mediums im ersten Volumen innerhalb der ersten Messstrecke charakterisierendes Signal bestimmt wird.

In einem zweiten Verfahrensschritt, der sowohl nach dem zuvor beschriebenen Verfahrensschritt als auch zeitgleich oder überlappend mit dem Verfahrensschritt ausgeführt werden kann, wird ein zweites Volumen des magnetisierten Mediums innerhalb der zweiten Messstrecke zu kernmagnetischen Resonanzen angeregt und wird ein zweiter Signalverlauf gebildet, indem mindestens ein die kernmagnetischen Resonanzen des Mediums im zweiten Volumen innerhalb der zweiten Messstrecke charakterisierendes Signal bestimmt wird.

In einem dritten Verfahrensschritt wird ein Quotientenverlauf bestimmt, indem jeweils ein Quotient aus dem mindestens einen Signal des ersten Signalverlaufs und aus dem mindestens einen Signal des zweiten Signalverlaufs bestimmt wird.

In einem vierten Verfahrensschritt wird eine Geschwindigkeit des Mediums unter Verwendung des Quotientenverlaufs bestimmt.

Die Lehre gemäß dem ersten Verfahren und die Lehre gemäß dem zweiten Verfahren weisen wesentliche Gemeinsamkeiten auf. Gemäß beiden Verfahren werden ein erstes Volumen und ein zweites Volumen des magnetisierten Mediums innerhalb von Messstrecken zu kernmagnetischen Resonanzen angeregt und werden ein erster Signalverlauf und ein zweiter Signalverlauf gebildet, indem jeweils mindestens ein die kernmagnetischen Resonanzen des Mediums in dem jeweiligen Volumen innerhalb der jeweiligen Messstrecke charakterisierendes Signal bestimmt wird. Auch wird gemäß beiden Verfahren ein Quotientenverlauf bestimmt, indem jeweils ein Quotient aus dem mindestens einen Signal des ersten Signalverlaufs und aus dem mindestens einen Signal des zweiten Signalverlaufs bestimmt wird und werden Geschwindigkeiten des strömenden Mediums unter Verwendung des Quotientenverlaufs bestimmt.

Die beiden Verfahren unterscheiden sich darin, dass gemäß dem ersten Verfahren nur eine Messstrecke verwendet wird, weshalb der erste Signalverlauf und der zweite Signalverlauf zeitlich nacheinander bestimmt werden müssen und dass gemäß dem zweiten Verfahren mindestens zwei Messstrecken, nämlich die erste Messstrecke und die zweite Messstrecke, verwendet werden, weshalb der erste Signalverlauf und der zweite Signalverlauf entweder zeitlich nacheinander oder auch gleichzeitig oder überlappend bestimmt werden können.

Ein Vorteil der erfindungsgemäßen Verfahren gegenüber den aus dem Stand der Technik bekannten Verfahren ist, dass die bestimmten Geschwindigkeiten eine geringere Abhängigkeit von Eigenschaften und vom Zustand des Mediums aufweisen. Das trifft insbesondere auf die Temperatur des Mediums zu. Die geringere Abhängigkeit der bestimmten Geschwindigkeiten von Eigenschaften und vom Zustand des Mediums ergibt sich durch die beschriebene Bestimmung des Quotientenverlaufs. Wenn zum Beispiel sowohl der erste Signalverlauf als auch der zweite Signalverlauf jeweils aus einem ersten Signal und einem zweiten Signal bestehen, wird der Quotientenverlauf bestimmt, indem ein erster Quotient aus dem jeweils ersten Signal des ersten Signalverlaufs und des zweiten Signalverlaufs und ein zweiter Quotient aus dem jeweils zweiten Signal des ersten Signalverlaufs und des zweiten Signalverlaufs bestimmt wird. Weisen sowohl der erste Signalverlauf als auch der zweite Signalverlauf mehr als jeweils zwei Signale auf, erfolgt die Bestimmung des Quotientenverlaufs entsprechend.

Die erste Messstrecke und die zweite Messstrecke gemäß dem zweiten Verfahren weisen zum Beispiel gleiche Längen oder verschiedene Längen auf, wobei die erste Messstrecke und die zweite Messstrecke sich nicht überlappen. Wenn die erste und die zweite Messstrecke die gleiche Länge aufweisen, dann müssen eine Geschwindigkeit des Mediums während des ersten Verfahrensschritts und eine Geschwindigkeit des Mediums während des zweiten Verfahrensschritts voneinander verschieden sein. Wenn die Längen verschieden sind, ist das nicht erforderlich aber auch nicht hinderlich. Vorzugsweise sind die erste Messstrecke und die zweite Messstrecke voneinander durch einen Abstand beabstandet. Wenn die zweite Messstrecke in Strömungsrichtung des Mediums im Messrohr hinter der ersten Messstrecke liegt, so ist der Abstand vorzugsweise größer als die Länge der zweiten Messstrecke. Auf diese Weise wird sichergestellt, dass das zweite Volumen des magnetisierten und angeregten Mediums aus der zweiten Messstrecke herausgeströmt ist, bevor das erste Volumen des magnetisierten und angeregten Mediums in die zweite Messstrecke hineinströmt. Befinden sich das erste Volumen und das zweite Volumen des magnetisierten und angeregten Mediums zeitgleich in der zweiten Messstrecke, wird der zweite Signalverlauf durch einen Beitrag des ersten Volumens des magnetisierten und angeregten Mediums innerhalb der zweiten Messstrecke verfälscht.

Der erste Signalverlauf und der zweite Signalverlauf werden jeweils gebildet, indem mindestens ein die kernmagnetischen Resonanzen des Mediums im jeweiligen der Volumen innerhalb der jeweiligen Messstrecken charakterisierendes Signal bestimmt wird. In einer ersten Ausgestaltung der erfindungsgemäßen Verfahren ist entweder vorgesehen, dass als das mindestens eine Signal im ersten Signalverlauf und als das mindestens eine Signal im zweiten Signalverlauf jeweils ein freier Induktionszerfall gemessen wird oder vorgesehen, dass als das mindestens eine Signal im ersten Signalverlauf oder als das mindestens eine Signal im zweiten Signalverlauf ein freier Induktionszerfall gemessen wird. Ein freier Induktionszerfall wird im Englischen als Free Induction Decay bezeichnet und als FID abgekürzt. Ein freier Induktionszerfall ist eine kernmagnetische Resonanz und wird durch einen elektromagnetischen Puls angeregt, der geeignet ist, Vektoren der magnetischen Momente der Atomkerne des magnetisierten Mediums zum Beispiel um 90° in Bezug auf einen Vektor des Magnetfelds zu drehen.

In einer Weiterbildung der vorangehenden Ausgestaltung ist entweder vorgesehen, dass als mindestens ein weiteres Signal im ersten Signalverlauf und als mindestens ein weiteres Signal im zweiten Signalverlauf jeweils ein Echosignal gemessen wird oder vorgesehen, dass als mindestens ein weiteres Signal im ersten Signalverlauf oder als mindestens ein weiteres Signal im zweiten Signalverlauf ein Echosignal gemessen wird. Ein Echosignal ist eine weitere kernmagnetische Resonanz und wird durch einen elektromagnetischen Puls angeregt, der geeignet ist, Vektoren der magnetischen Momente der Atomkerne des magnetisierten Mediums zum Beispiel um 180° in Bezug auf den Vektor des Magnetfelds zu drehen.

Somit besteht ein Signalverlauf aus mindestens einem Signal. Wenn ein Signalverlauf aus mindestens einem ersten Signal und einem nach dem ersten Signal zeitlich folgenden zweiten Signal besteht, so bietet es sich an, dass als das erste Signal ein freier Induktionszerfall gemessen wird und als das zweite Signal ein Echosignal gemessen wird. Wenn der Signalverlauf zeitlich auf das zweite Signal folgend noch weitere Signale aufweist, so bietet es sich an, als die weiteren Signale weitere Echosignale zu messen. Alternativ dazu kann auch sowohl als erstes Signal als auch als zweites Signal und/oder die weiteren Signale jeweils ein freier Induktionszerfall gemessen werden.

Zur Messung der Signale in den Signalverläufen werden Messungen von kernmagnetischen Resonanzen am angeregten Medium innerhalb der jeweiligen Messstrecke durchgeführt. In einer weiteren Ausgestaltung der Verfahren ist entweder vorgesehen, dass zur Bestimmung des mindestens einen Signals im ersten Signalverlauf und des mindestens einen Signals im zweiten Signalverlauf jeweils eine Messung am Medium über einem Intervall ausgeführt wird und die Messung über das Intervall integriert oder ein Mittelwert über die Messung gebildet wird oder ist vorgesehen, dass zur Bestimmung des mindestens einen Signals im ersten Signalverlauf oder des mindestens einen Signals im zweiten Signalverlauf eine Messung am Medium über ein Intervall ausgeführt wird oder die Messung über da Intervall integriert oder ein Mittelwert über die Messung gebildet wird.

Grundsätzlich ist es ausreichend, wenn jeder der Signalverläufe jeweils nur ein einziges Signal aufweist. Dann bietet es sich jedoch an, die Verfahren nicht nur einmal, sondern mehrfach auszuführen. In einer weiteren Ausgestaltung ist dagegen entweder vorgesehen, dass der erste Signalverlauf und der zweite Signalverlauf gebildet werden, indem mindestens jeweils zwei Signale bestimmt werden. Oder es ist vorgesehen, dass der erste Signalverlauf oder der zweite Signalverlauf gebildet wird, indem mindestens zwei Signale bestimmt werden. Wenn sowohl der erste Signalverlauf als auch der zweite Signalverlauf jeweils mindestens zwei Signale aufweisen, so weist der Quotientenverlauf mindestens zwei Quotienten auf und es bietet sich dann an, dass der Quotientenverlauf durch eine Funktion interpoliert wird. Die Funktion wird dann zum Beispiel aus einem Produkt aus mehreren Basisfunktionen bestimmt. Als Basisfunktionen werden zum Beispiel Polynomfunktionen und Exponentialfunktionen verwendet. Wenn der Quotientenverlauf aus mindestens zwei Quotienten besteht, so bietet es sich auch an, dass der Quotientenverlauf durch ein Taylorpolynom angenähert wird.

Zur weiteren Verbesserung der Genauigkeit der Bestimmung einer Geschwindigkeit des durch das Messrohr strömenden Mediums ist in einer weiteren Ausgestaltung vorgesehen, dass eine Temperatur des Mediums bestimmt wird und die Temperatur bei der Bestimmung des Quotientenverlaufs verwendet wird.

Darüber hinaus eröffnen die erfindungsgemäßen Verfahren auch die Möglichkeit, eine Spin-Spin-Relaxationszeitkonstante des Mediums zu bestimmen. Die Spin-Spin-Relaxationszeitkonstante ist insbesondere von der Temperatur des Mediums abhängig und beeinflusst den ersten Faktor, der die Abnahme der Signale beschreibt. Deshalb ist in einer weiteren Ausgestaltung der erfindungsgemäßen Verfahren vorgesehen, dass die Spin-Spin-Relaxationszeitkonstante des Mediums unter Verwendung des Quotientenverlaufs und/oder unter Verwendung des mindestens einen Signals des ersten Signalverlaufs und/oder unter Verwendung des mindestens einen Signals des zweiten Signalverlaufs bestimmt wird.

Die Erfindung bezieht sich auch auf kernmagnetische Durchflussmessgeräte, bei denen die hergeleitete und aufgezeigte Aufgabe gelöst ist. Die kernmagnetischen Durchflussmessgeräte weisen ein Messrohr, eine Magnetisierungseinrichtung und eine Messeinrichtung auf. Dabei weist das Messrohr mindestens eine erste Messstrecke auf. Im Betrieb eines kernmagnetischen Durchflussmessgeräts strömt ein Medium durch das Messrohr und die Magnetisierungseinrichtung magnetisiert das Medium im Messrohr.

Ein solches kernmagnetisches Durchflussmessgerät, bei dem das Messrohr eine erste Messstrecke aufweist, ist gemäß einer weiteren Lehre der Erfindung zunächst und im Wesentlichen dadurch gekennzeichnet, dass die Messeinrichtung ausgebildet ist, im Betrieb ein mit einer ersten Geschwindigkeit strömendes erstes Volumen des magnetisierten Mediums innerhalb der ersten Messstrecke zur kernmagnetischen Resonanz anzuregen und einen ersten Signalverlauf zu bilden, indem die Messeinrichtung mindestens ein die kernmagnetischen Resonanzen des Mediums im ersten Volumen innerhalb der ersten Messstrecke charakterisierendes Signal bestimmt. Die Messeinrichtung ist weiterhin ausgebildet, anschließend ein mit einer zweiten Geschwindigkeit strömendes zweites Volumen des magnetisierten Mediums innerhalb der ersten Messstrecke zur kernmagnetischen Resonanz anzuregen und einen zweiten Signalverlauf zu bilden, indem die Messeinrichtung mindestens ein die kernmagnetischen Resonanzen des Mediums im zweiten Volumen innerhalb der ersten Messstrecke charakterisierendes Signal bestimmt. Weiterhin ist die Messeinrichtung zum einen ausgebildet, einen Quotientenverlauf zu bestimmen, indem die Messeinrichtung jeweils einen Quotienten aus dem mindestens einen Signal des ersten Signalverlaufs und aus dem mindestens einen Signal des zweiten Signalverlaufs bestimmt, und zum anderen ausgebildet, die erste Geschwindigkeit und/oder die zweite Geschwindigkeit unter Verwendung des Quotientenverlaufs zu bestimmen.

Ein kernmagnetisches Durchflussmessgerät, bei dem das Messrohr eine erste Messstrecke und eine zweite Messstrecke aufweist, ist gemäß einer zur vorangehenden Lehre alternativen Lehre der Erfindung zunächst und im Wesentlichen dadurch gekennzeichnet, dass die Magnetisierungseinrichtung ausgebildet ist, im Betrieb ein erstes Volumen des magnetisierten Mediums innerhalb der ersten Messstrecke zu kernmagnetischen Resonanzen anzuregen und einen ersten Signalverlauf zu bilden, indem die Messeinrichtung mindestens ein die kernmagnetischen Resonanzen des Mediums im ersten Volumen innerhalb der ersten Messstrecke charakterisierendes Signal bestimmt. Weiterhin ist die Messeinrichtung ausgebildet, ein zweites Volumen des magnetisierten Mediums innerhalb der zweiten Messstrecke zu kernmagnetischen Resonanzen anzuregen und einen zweiten Signalverlauf zu bilden, indem die Messeinrichtung mindestens einen die kernmagnetischen Resonanzen des Mediums im zweiten Volumen innerhalb der zweiten Messstrecke charakterisierendes Signal bestimmt. Darüber hinaus ist die Messeinrichtung zum einen ausgebildet, einen Quotientenverlauf zu bestimmen, indem die Messeinrichtung jeweils einen Quotienten aus dem mindestens einen Signal des ersten Signalverlaufs und aus dem mindestens einen Signal des zweiten Signalverlaufs bestimmt, und zum anderen ausgebildet, eine Geschwindigkeit des Mediums unter Verwendung des Quotientenverlaufs zu bestimmen.

Eine Ausgestaltung der erfindungsgemäßen kernmagnetischen Durchflussmessgeräte sieht vor, dass die Messeinrichtung zur Ausführung eines der beschriebenen Verfahren ausgebildet ist.

Die Ausführungen zu den Verfahren zum Betreiben von kernmagnetischen Durchflussmessgeräten gelten entsprechend für die kernmagnetischen Durchflussmessgeräte und umgekehrt.

Im Einzelnen ist eine Vielzahl von Möglichkeiten gegeben, die erfindungsgemäßen Verfahren und die erfindungsgemäßen kernmagnetischen Durchflussmessgeräte auszugestalten und weiterzubilden. Dazu wird verwiesen sowohl auf die den unabhängigen Patentansprüchen nachgeordneten Patentansprüche als auch auf die nachfolgende Beschreibung von bevorzugten Ausführungsbeispielen in Verbindung mit der Zeichnung. In der Zeichnung zeigt
- Fig. 1: ein Ausführungsbeispiel eines kernmagnetischen Durchflussmessgeräts,
- Fig. 2: einen Längsschnitt durch das kernmagnetische Durchflussmessgerät aus Fig. 1,
- Fig. 3: den Längsschnitt aus Fig. 2 im Betrieb des kernmagnetischen Durchflussmessgeräts bei Ausführung eines ersten Verfahrens zu einem ersten Zeitpunkt,
- Fig. 4: den Längsschnitt des kernmagnetischen Durchflussmessgeräts im Betrieb bei Ausführung des ersten Verfahrens zu einem zweiten Zeitpunkt,
- Fig. 5: den Längsschnitt des kernmagnetischen Durchflussmessgeräts im Betrieb bei Ausführung des ersten Verfahrens zu einem dritten Zeitpunkt,
- Fig. 6: den Längsschnitt des kernmagnetischen Durchflussmessgeräts im Betrieb bei Ausführung des ersten Verfahrens zu einem vierten Zeitpunkt,
- Fig. 7: einen Ablaufplan des ersten Verfahrens,
- Fig. 8: den Längsschnitt des kernmagnetischen Durchflussmessgeräts im Betrieb bei Ausführung eines zweiten Verfahrens zu einem fünften Zeitpunkt,
- Fig. 9: den Längsschnitt des kernmagnetischen Durchflussmessgeräts im Betrieb bei Ausführung des zweiten Verfahrens zu einem sechsten Zeitpunkt und
- Fig. 10: einen Ablaufplan des zweiten Verfahrens.

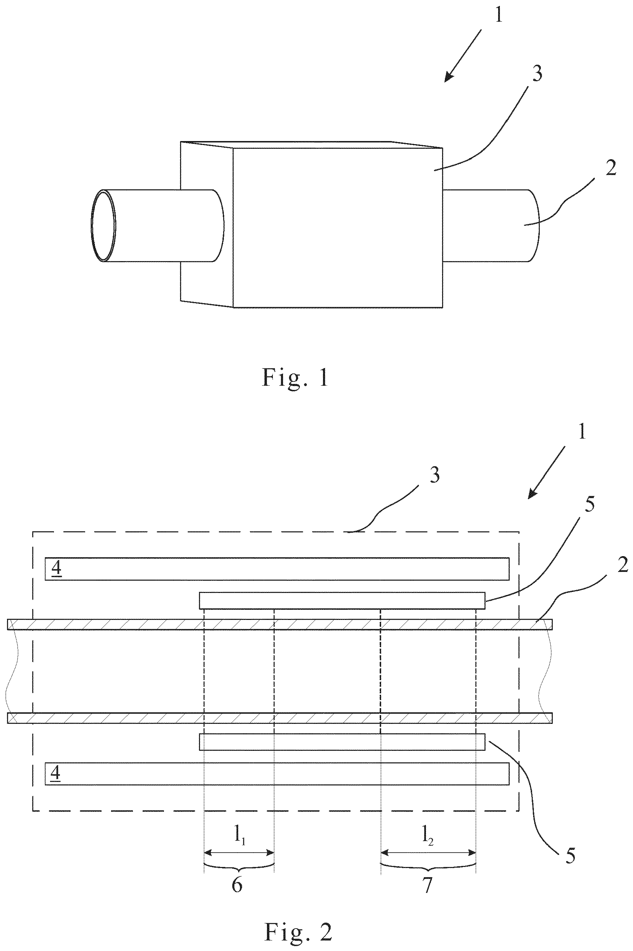

Fig. 1 zeigt in einer abstrahierten perspektivischen Darstellung das kernmagnetische Durchflussmessgerät 1. Das kernmagnetische Durchflussmessgerät 1 weist das Messrohr 2 und das Gehäuse 3 auf.

Fig. 2 zeigt einen Längsschnitt durch das kernmagnetische Durchflussmessgerät 1. Der Längsschnitt macht wesentliche Komponenten des kernmagnetischen Durchflussmessgeräts 1 im Gehäuse 3 sichtbar. So weist das kernmagnetische Durchflussmessgerät 1 die im Gehäuse 3 angeordnete Magnetisierungseinrichtung 4 und die Messeinrichtung 5 auf. Das Messrohr 2 weist dabei die erste Messstrecke 6 mit der Länge l₁ und die zweite Messstrecke 7 mit der Länge l₂ auf, wobei die Länge l₂ der zweiten Messstrecke 7 größer ist als die Länge l₁ der ersten Messstrecke 6.

Die Magnetisierungseinrichtung 4 ist ausgebildet, ein durch das Messrohr 2 strömendes Medium auch über die erste Messstrecke 6 und über die zweite Messstrecke 7 mit einem magnetischen Feld zu durchsetzen. Dabei magnetisiert das magnetische Feld ein Medium derart, dass es zu kernmagnetischen Resonanzen anregbar ist.

Die Messeinrichtung 5 ist ausgebildet, im Betrieb zum einen ein von der Magnetisierungseinrichtung 4 magnetisiertes Medium zu kernmagnetischen Resonanzen anzuregen und zum anderen Signale zu bestimmen, welche die kernmagnetischen Resonanzen des Mediums charakterisieren.

Die Messeinrichtung 5 erzeugt in diesem Ausführungsbeispiel zur Anregung eines magnetisierten Mediums im Messrohr 2 zunächst einen elektromagnetischen Puls, welcher geeignet ist, die Vektoren der magnetischen Momente der Atomkerne des magnetisieren Mediums um 90° in Bezug auf einen Vektor des Magnetfelds zu drehen. Die durch diesen elektromagnetischen Puls angeregte kernmagnetische Resonanz ist ein freier Induktionszerfall und die Messeinrichtung 5 misst diesen freien Induktionszerfall und bestimmt aus diesem ein den freien Induktionszerfall charakterisierendes Signal. Die Messung des Signals wird dabei von der Messeinrichtung 5 in diesem Ausführungsbeispiel über ein Intervall ausgeführt und die Messung über das Intervall integriert. Alternativ zur Integration kann auch ein Mittelwert über die Messung gebildet werden.

Nach dem Abklingen des freien Induktionszerfalls regt die Magnetisierungseinrichtung 4 das magnetisierte Medium dann zu weiteren kernmagnetischen Resonanzen an. Dazu erzeugt die Messeinrichtung 5 in diesem Ausführungsbeispiel jeweils einen elektromagnetischen Puls, der geeignet ist, die Vektoren der magnetischen Momente der Atomkerne des Mediums um 180° in Bezug auf den Vektor des Magnetfelds zu drehen. Auf diese Weise wird jeweils ein Echosignal angeregt, das von der Messeinrichtung 5 gemessen wird. Die Messungen erfolgen dabei wie die Messung des freien Induktionszerfalls.

Die Messeinrichtung 5 ist darüber hinaus ausgebildet, ein magnetisiertes Medium unabhängig voneinander innerhalb der ersten Messstrecke 6 und innerhalb der zweiten Messstrecke 7 zu kernmagnetischen Resonanzen anzuregen, die kernmagnetischen Resonanzen zu messen und aus den gemessenen kernmagnetischen Resonanzen diese charakterisierende Signale zu bestimmen. Dabei bedeutet 'unabhängig voneinander', dass entweder ein magnetisiertes Medium innerhalb der ersten Messstrecke 6 und innerhalb der zweiten Messstrecke 7 angeregt und gemessen wird oder dass ein magnetisiertes Medium innerhalb der ersten Messstrecke 6 oder innerhalb der zweiten Messstrecke 7 angeregt und gemessen wird.

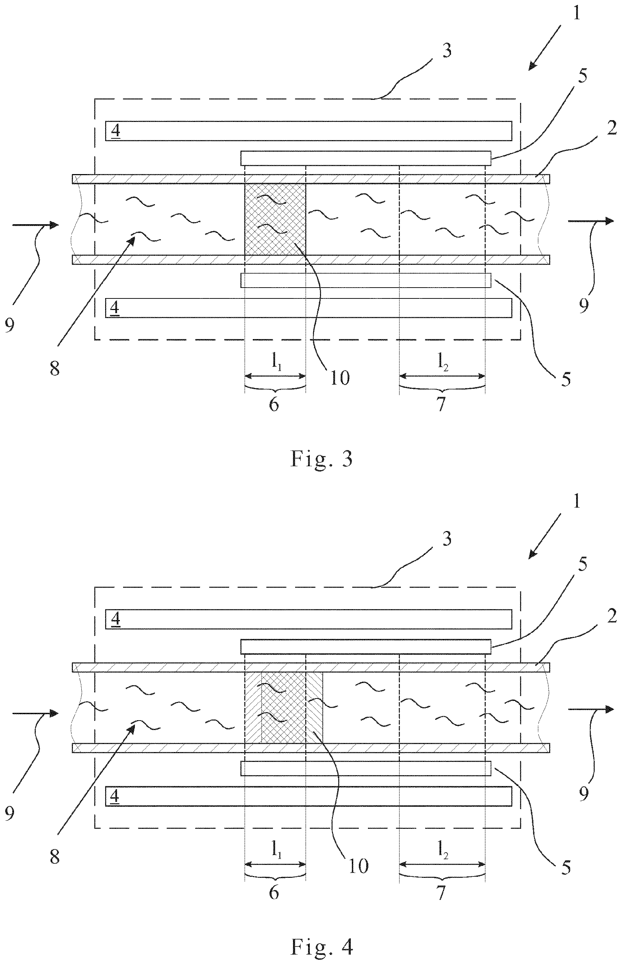

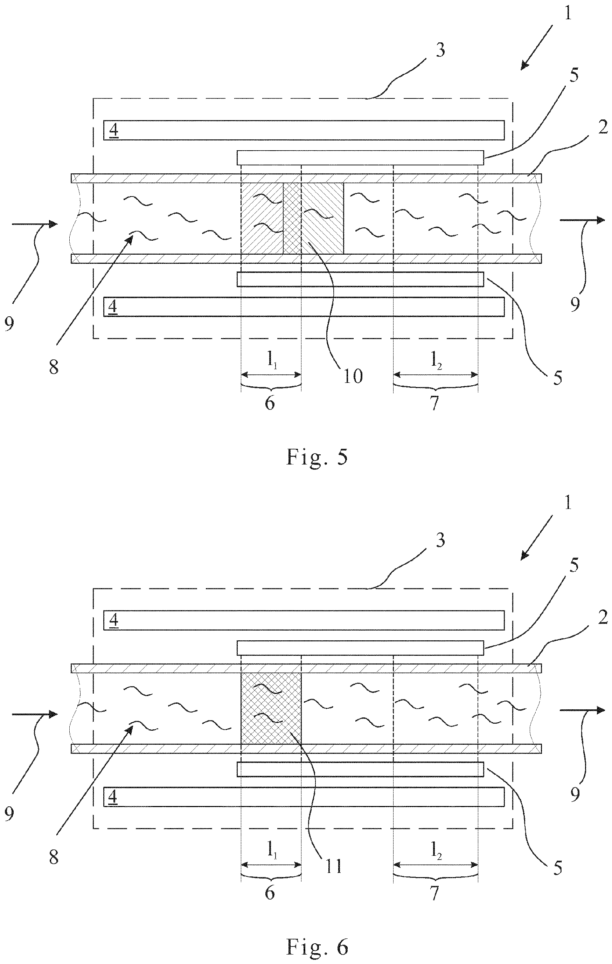

Die Fig. 3 bis 6 zeigen das kernmagnetische Durchflussmessgerät 1 im Betrieb zu verschiedenen Zeitpunkten. Fig. 3 zeigt das kernmagnetische Durchflussmessgerät 1 zu einem ersten Zeitpunkt, Fig. 4 zu einem zweiten Zeitpunkt, Fig. 5 zu einem dritten Zeitpunkt und Fig. 6 zu einem vierten Zeitpunkt. Das Medium 8 strömt dabei in Richtung 9 durch das Messrohr 2, wobei es durch die Magnetisierungseinrichtung 4 magnetisiert wird, sodass es zu kernmagnetischen Resonanzen anregbar ist. Die Messeinrichtung 5 führt im Betrieb des kernmagnetischen Durchflussmessgeräts 1 zunächst ein erstes Verfahren aus. Das erste Verfahren erfordert nur eine einzige Messstrecke und in diesem Ausführungsbeispiel wird nur die erste Messstrecke 6 verwendet, jedoch könnte genauso gut auch die zweite Messstrecke 7 anstelle der ersten Messstrecke 6 verwendet werden. Auch könnte ein kernmagnetisches Durchflussmessgerät mit nur einer einzigen Messstrecke verwendet werden.

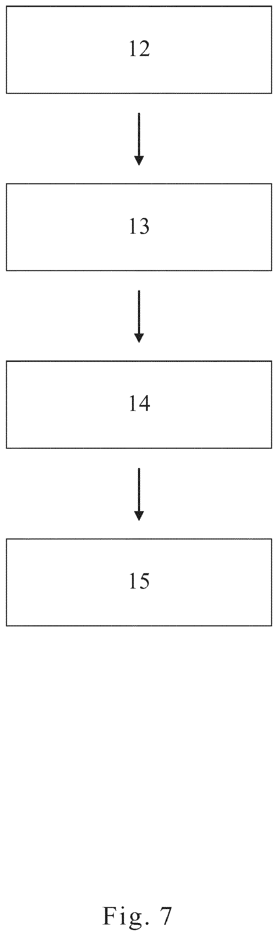

Die Messeinrichtung 5 führt das erste Verfahren aus, wobei das erste Verfahren die im Ablaufplan in Fig. 7 dargestellten Verfahrensschritten aufweist:
In dem ersten Verfahrensschritt 12 wird das mit einer ersten Geschwindigkeit strömende erste Volumen 10 des magnetisierten Mediums 8 innerhalb der ersten Messstrecke 6 zeitlich nacheinander zu drei kernmagnetischen Resonanzen angeregt und wird ein erster Signalverlauf gebildet. Der erste Signalverlauf wird gebildet, indem für jede der kernmagnetischen Resonanzen des Mediums 8 ein die jeweilige kernmagnetische Resonanz im ersten Volumen 10 innerhalb der ersten Messstrecke 6 charakterisierendes Signal bestimmt wird. Somit weist der erste Signalverlauf drei Signale auf.

Zum in Fig. 3 dargestellten ersten Zeitpunkt regt die Messeinrichtung 5 das erste Volumen 10 des magnetisierten Mediums 8 über die gesamte Länge l₁ der ersten Messstrecke 6 zu einem freien Induktionszerfall an. Die Messung zur Bestimmung eines ersten der drei Signale erfolgt am angeregten Medium 8 im Volumen 10 ebenfalls über die gesamte Länge l₁ der ersten Messstrecke 6.

Zwischen dem in Fig. 3 dargestellten ersten Zeitpunkt und dem in Fig. 4 dargestellten zweiten Zeitpunkt strömt ein Teil des ersten Volumens 10 des Mediums 8 mit der ersten Geschwindigkeit in Richtung 9 aus der ersten Messstrecke 6 heraus. Der zum zweiten Zeitpunkt noch innerhalb der ersten Messstrecke 6 verbliebene Teil des ersten Volumens 10 des Mediums 8 ist mit einer Kreuzschraffur kenntlich gemacht. Zum zweiten Zeitpunkt regt die Messeinrichtung 5 den innerhalb der ersten Messstrecke 6 verbliebenen Teil des ersten Volumens 10 des magnetisierten Mediums 8 zu einem ersten Echosignal an. Die Messung zur Bestimmung eines zweiten der drei Signale erfolgt wieder über die gesamte Länge l₁ der ersten Messstrecke 6. Jedoch liefert nur noch der in der ersten Messstrecke 6 verbliebene Teil des Volumens 10 des Mediums 8 einen Beitrag zum zweiten Signal.

Zwischen dem in Fig. 4 dargestellten zweiten Zeitpunkt und dem in Fig. 5 dargestellten dritten Zeitpunkt strömt ein weiterer Teil des ersten Volumens 10 des Mediums 8 mit der ersten Geschwindigkeit in Richtung 9 aus der ersten Messstrecke 6 heraus. Der zum dritten Zeitpunkt noch innerhalb der ersten Messstrecke 6 verbliebene Teil des ersten Volumens 10 des Mediums 8 ist wieder mit einer Kreuzschraffur kenntlich gemacht. Zum dritten Zeitpunkt regt die Messeinrichtung 5 den innerhalb der ersten Messstrecke 6 verbliebenen Teil des ersten Volumens 10 des magnetisierten Mediums 8 zu einem zweiten Echosignal an. Die Messung zur Bestimmung eines dritten der drei Signale erfolgt wieder über die gesamte Länge l₁ der ersten Messstrecke 6. Jedoch liefert wieder nur noch der in der ersten Messstrecke 6 verbliebene Teil des Volumens 10 des Mediums 8 einen Beitrag zum dritten Signal.

Die vorstehenden Erläuterungen zu den verschiedenen Zeitpunkten des ersten Verfahrens sind für die beschriebenen Verfahren entsprechend allgemeingültig.

In dem zweiten Verfahrensschritt 13 wird nach dem Ausführen des ersten Verfahrensschritts 12 das mit einer zweiten Geschwindigkeit strömende zweite Volumen 11 des magnetisierten Mediums 8 innerhalb der ersten Messstrecke 6 zeitlich nacheinander zu drei kernmagnetischen Resonanzen angeregt und wird ein zweiter Signalverlauf gebildet. Der zweite Signalverlauf wird gebildet, indem für jede der kernmagnetischen Resonanzen des Mediums 8 ein die jeweilige kernmagnetische Resonanz im zweiten Volumen 11 innerhalb der ersten Messstrecke 6 charakterisierendes Signal bestimmt wird. Somit weist auch der zweite Signalverlauf drei Signale auf.

Zum in Fig. 6 dargestellten vierten Zeitpunkt regt die Messeinrichtung 5 das zweite Volumen 11 des magnetisierten Mediums 8 über die gesamte Länge l₁ der ersten Messstrecke 6 zu einem freien Induktionszerfall an. Die Messung zur Bestimmung eines ersten der drei Signale erfolgt am angeregten Medium 8 im Volumen 11 über die gesamte Länge l₁ der ersten Messstrecke 6. Im Übrigen gelten die Ausführungen zum ersten Verfahrensschritt 12.

In dem dritten Verfahrensschritt 14 wird ein Quotientenverlauf bestimmt, indem jeweils ein Quotient aus den drei Signalen des ersten Signalverlaufs und aus den drei Signalen des zweiten Signalverlaufs bestimmt wird. Somit weist der Quotientenverlauf drei Quotienten auf, wobei der erste Quotient aus dem ersten Signal des ersten Signalverlaufs und aus dem ersten Signal des zweiten Signalverlaufs, der zweite Quotient aus dem zweiten Signal des ersten Signalverlaufs und dem zweiten Signal des zweiten Signalverlaufs und der dritte Quotient aus dem dritten Signal des ersten Signalsverlaufs und dem dritten Signal des zweiten Signalverlaufs bestimmt wird.

In dem vierten Verfahrensschritt 15 werden die zuvor unbekannte erste Geschwindigkeit und die zuvor unbekannte zweite Geschwindigkeit des Mediums 8 unter Verwendung des Quotientenverlaufs bestimmt.

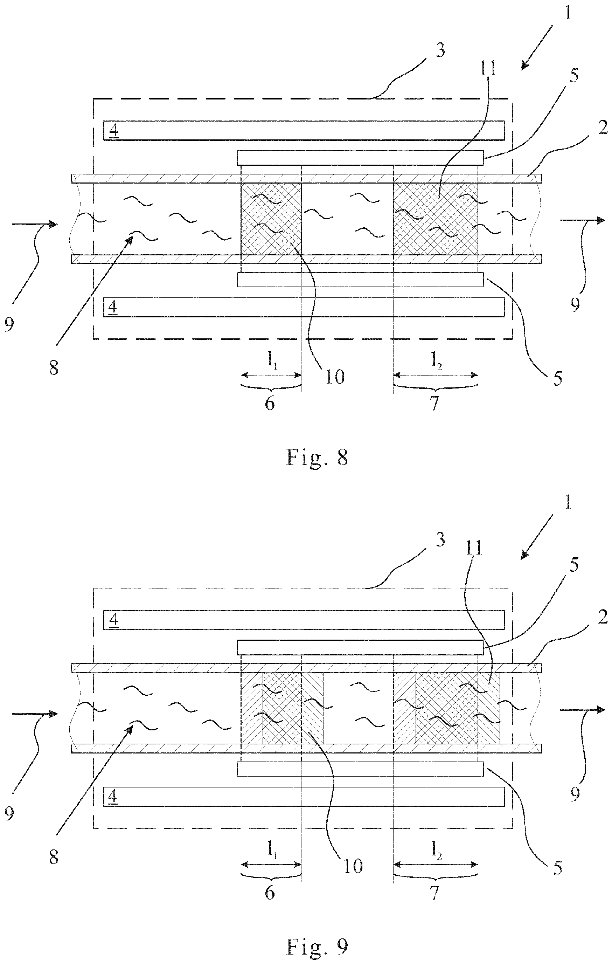

Die Fig. 8 und 9 zeigen das kernmagnetische Durchflussmessgerät 1 im Betrieb zu weiteren Zeitpunkten. Fig. 8 zeigt das kernmagnetische Durchflussmessgerät 1 zu einem fünften Zeitpunkt und Fig. 9 zu einem späteren sechsten Zeitpunkt. Das Medium 8 strömt dabei noch immer in Richtung 9 durch das Messrohr 2, wobei es durch die Magnetisierungseinrichtung 4 magnetisiert wird, sodass es zu kernmagnetischen Resonanzen anregbar ist. Die Messeinrichtung 5 führt im Betrieb des kernmagnetischen Durchflussmessgeräts 1 nun ein zweites Verfahren aus. Das zweite Verfahren erfordert jedoch im Gegensatz zum ersten Verfahren neben der ersten Messstrecke 6 noch die zweite Messstrecke 7.

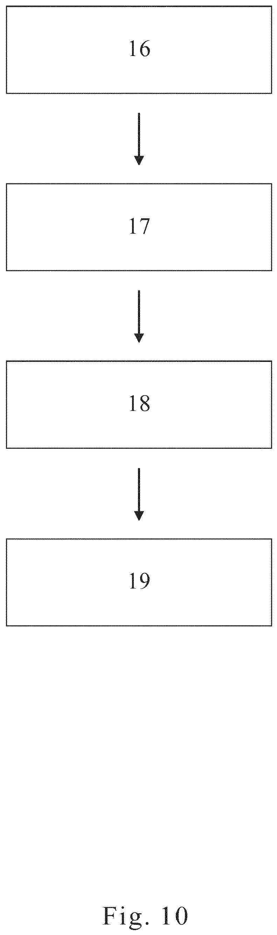

Die Messeinrichtung 5 führt das zweite Verfahren aus, wobei das zweite Verfahren die im Ablaufplan in Fig. 10 dargestellten Verfahrensschritten aufweist:
In dem ersten Verfahrensschritt 16 wird das mit einer Geschwindigkeit strömende erste Volumen 10 des magnetisierten Mediums 8 innerhalb der ersten Messstrecke 6 zeitlich nacheinander zu zwei kernmagnetischen Resonanzen angeregt und wird ein erster Signalverlauf gebildet. Der erste Signalverlauf wird gebildet, indem für jede der kernmagnetischen Resonanzen des Mediums 8 ein die jeweilige kernmagnetische Resonanz im ersten Volumen 10 innerhalb der ersten Messstrecke 6 charakterisierendes Signal bestimmt wird. Somit weist der erste Signalverlauf zwei Signale auf.

Zum in Fig. 8 dargestellten fünften Zeitpunkt regt die Messeinrichtung 5 das erste Volumen 10 des magnetisierten Mediums 8 über die gesamte Länge l₁ der ersten Messstrecke 6 zu einem freien Induktionszerfall an. Die Messung zur Bestimmung eines ersten der zwei Signale erfolgt am angeregten Medium 8 im Volumen 10 ebenfalls über die gesamte Länge l₁ der ersten Messstrecke 6.

Zwischen dem in Fig. 8 dargestellten fünften Zeitpunkt und dem in Fig. 9 dargestellten sechsten Zeitpunkt strömt ein Teil des ersten Volumens 10 des Mediums 8 mit einer Geschwindigkeit in Richtung 9 aus der ersten Messstrecke 6 heraus. Der zum sechsten Zeitpunkt noch innerhalb der ersten Messstrecke 6 verbliebene Teil des ersten Volumens 10 des Mediums 8 ist mit einer Kreuzschraffur kenntlich gemacht. Zum sechsten Zeitpunkt regt die Messeinrichtung 5 den innerhalb der ersten Messstrecke 6 verbliebenen Teil des ersten Volumens 10 des magnetisierten Mediums 8 zu einem Echosignal an. Die Messung zur Bestimmung eines zweiten der zwei Signale erfolgt über die gesamte Länge l₁ der ersten Messstrecke 6. Jedoch liefert nur noch der in der ersten Messstrecke 6 verbliebene Teil des Volumens 10 des Mediums 8 einen Beitrag zum zweiten Signal.

In dem zweiten Verfahrensschritt 17 wird synchron zum Ausführen des ersten Verfahrensschritts 16 das mit der Geschwindigkeit strömende zweite Volumen 11 des magnetisierten Mediums 8 innerhalb der zweiten Messstrecke 7 zeitlich nacheinander zu zwei kernmagnetischen Resonanzen angeregt und wird ein zweiter Signalverlauf gebildet. Der zweite Signalverlauf wird gebildet, indem für jede der kernmagnetischen Resonanzen des Mediums 8 ein die jeweilige kernmagnetische Resonanz im zweiten Volumen 11 innerhalb der zweiten Messstrecke 7 charakterisierendes Signal bestimmt wird. Somit weist auch der zweite Signalverlauf zwei Signale auf.

Zum in Fig. 8 dargestellten fünften Zeitpunkt regt die Messeinrichtung 5 das zweite Volumen 11 des magnetisierten Mediums 8 über die gesamte Länge l₂ der zweiten Messstrecke 7 zu einem freien Induktionszerfall an. Die Messung zur Bestimmung eines ersten der zwei Signale erfolgt am angeregten Medium 8 im Volumen 11 ebenfalls über die gesamte Länge l₂ der zweiten Messstrecke 7.

Zwischen dem in Fig. 8 dargestellten fünften Zeitpunkt und dem in Fig. 9 dargestellten sechsten Zeitpunkt strömt ein Teil des zweiten Volumens 11 des Mediums 8 mit der Geschwindigkeit in Richtung 9 aus der zweiten Messstrecke 7 heraus. Der zum sechsten Zeitpunkt noch innerhalb der zweiten Messstrecke 7 verbliebene Teil des zweiten Volumens 11 des Mediums 8 ist mit einer Kreuzschraffur kenntlich gemacht. Zum sechsten Zeitpunkt regt die Messeinrichtung 5 den innerhalb der zweiten Messstrecke 7 verbliebenen Teil des zweiten Volumens 11 des magnetisierten Mediums 8 zu einem Echosignal an. Die Messung zur Bestimmung eines zweiten der zwei Signale erfolgt über die gesamte Länge l₂ der zweiten Messstrecke 7. Jedoch liefert nur noch der in der zweiten Messstrecke 7 verbliebene Teil des Volumens 11 des Mediums 8 einen Beitrag zum zweiten Signal.

Die vorstehenden Erläuterungen zu den verschiedenen Zeitpunkten des zweiten Verfahrens sind für die beschriebenen Verfahren entsprechend allgemeingültig.

In dem dritten Verfahrensschritt 18 wird ein Quotientenverlauf bestimmt, indem jeweils ein Quotient aus den zwei Signalen des ersten Signalverlaufs und aus den zwei Signalen des zweiten Signalverlaufs bestimmt wird. Somit weist der Quotientenverlauf zwei Quotienten auf, wobei der erste Quotient aus dem ersten Signal des ersten Signalverlaufs und aus dem ersten Signal des zweiten Signalverlaufs und der zweite Quotient aus dem zweiten Signal des ersten Signalverlaufs und dem zweiten Signal des zweiten Signalverlaufs bestimmt wird.

In dem vierten Verfahrensschritt 19 wird die zuvor unbekannte Geschwindigkeit des Mediums 8 unter Verwendung des Quotientenverlaufs bestimmt.

Im Übrigen gelten die Ausführungen zum ersten Verfahren.

### Bezugszeichen

- 1: Kernmagnetisches Durchflussmessgerät
- 2: Messrohr
- 3: Gehäuse
- 4: Magnetisierungseinrichtung
- 5: Messeinrichtung
- 6: Erste Messstrecke
- 7: Zweite Messstrecke
- 8: Medium
- 9: Strömungsrichtung des Mediums
- 10: Erstes Volumen
- 11: Zweites Volumen
- 12: Erster Verfahrensschritt eines ersten Verfahrens
- 13: Zweiter Verfahrensschritt des ersten Verfahrens
- 14: Dritter Verfahrensschritt des ersten Verfahrens
- 15: Vierter Verfahrensschritt des ersten Verfahrens
- 16: Erster Verfahrensschritt eines zweiten Verfahrens
- 17: Zweiter Verfahrensschritt des zweiten Verfahrens
- 18: Dritter Verfahrensschritt des zweiten Verfahrens
- 19: Vierter Verfahrensschritt des zweiten Verfahrens

## Patentansprüche

1. Verfahren zum Betreiben eines kernmagnetischen Durchflussmessgeräts (1), wobei das kernmagnetische Durchflussmessgerät (1) ein Messrohr (2) mit einer ersten Messstrecke (6) aufweist, ein Medium (8) durch das Messrohr (2) geströmt wird und das Medium (8) im Messrohr (2) magnetisiert wird,
**dadurch gekennzeichnet,**
- **dass** ein mit einer ersten Geschwindigkeit strömendes erstes Volumen (10) des magnetisierten Mediums (8) innerhalb der ersten Messstrecke (6) zu kernmagnetischen Resonanzen angeregt wird und ein erster Signalverlauf gebildet wird, indem mindestens ein die kernmagnetischen Resonanzen des Mediums (8) im ersten Volumen (10) innerhalb der ersten Messstrecke (6) charakterisierendes Signal bestimmt wird,
- **dass** anschließend ein mit einer zweiten Geschwindigkeit strömendes zweites Volumen (11) des magnetisierten Mediums (8) innerhalb der ersten Messstrecke (6) zu kernmagnetischen Resonanzen angeregt wird und ein zweiter Signalverlauf gebildet wird, indem mindestens ein die kernmagnetischen Resonanzen des Mediums (8) im zweiten Volumen (11) innerhalb der ersten Messstrecke (6) charakterisierendes Signal bestimmt wird,
- **dass** ein Quotientenverlauf bestimmt wird, indem jeweils ein Quotient aus dem mindestens einen Signal des ersten Signalverlaufs und aus dem mindestens einen Signal des zweiten Signalverlaufs bestimmt wird und
- **dass** die erste Geschwindigkeit und/oder die zweite Geschwindigkeit unter Verwendung des Quotientenverlaufs bestimmt werden bzw. wird.

2. Verfahren zum Betreiben eines kernmagnetischen Durchflussmessgeräts (1), wobei das kernmagnetische Durchflussmessgerät (1) ein Messrohr (2) mit einer ersten Messstrecke (6) und einer zweiten Messstrecke (7) aufweist, ein Medium (8) durch das Messrohr (2) geströmt wird und das Medium im Messrohr (2) magnetisiert wird,
**dadurch gekennzeichnet,**
- **dass** ein erstes Volumen (10) des magnetisierten Mediums (8) innerhalb der ersten Messstrecke (6) zu kernmagnetischen Resonanzen angeregt wird und ein erster Signalverlauf gebildet wird, indem mindestens ein die kernmagnetischen Resonanzen des Mediums (8) im ersten Volumen (10) innerhalb der ersten Messstrecke (6) charakterisierendes Signal bestimmt wird,
- **dass** ein zweites Volumen (11) des magnetisierten Mediums (8) innerhalb der zweiten Messstrecke (7) zu kernmagnetischen Resonanzen angeregt wird und ein zweiter Signalverlauf gebildet wird, indem mindestens ein die kernmagnetischen Resonanzen des Mediums (8) im zweiten Volumen (11) innerhalb der zweiten Messstrecke (7) charakterisierendes Signal bestimmt wird,
- **dass** ein Quotientenverlauf bestimmt wird, indem jeweils ein Quotient aus dem mindestens einen Signal des ersten Signalverlaufs und aus dem mindestens einen Signal des zweiten Signalverlaufs bestimmt wird und
- **dass** eine Geschwindigkeit des Mediums (8) unter Verwendung des Quotientenverlaufs bestimmt wird.

3. Verfahren nach Anspruch 1 oder 2, **dadurch gekennzeichnet, dass** als das mindestens eine Signal im ersten Signalverlauf und/oder als das mindestens eine Signal im zweiten Signalverlauf ein freier Induktionszerfall gemessen wird.

4. Verfahren nach Anspruch 3, **dadurch gekennzeichnet, dass** als mindestens ein weiteres Signal im ersten Signalverlauf und/oder als mindestens ein weiteres Signal im zweiten Signalverlauf ein Echosignal gemessen wird.

5. Verfahren nach einem der Ansprüche 1 bis 4, **dadurch gekennzeichnet, dass** zur Bestimmung des mindestens einen Signals im ersten Signalverlauf und/oder des mindestens einen Signals im zweiten Signalverlauf eine Messung am Medium (8) über ein Intervall ausgeführt wird und die Messung über das Intervall integriert oder ein Mittelwert über die Messung gebildet wird.

6. Verfahren nach einem der Ansprüche 1 bis 5, **dadurch gekennzeichnet, dass** der erste Signalverlauf und/oder der zweite Signalverlauf gebildet werden bzw. gebildet wird, indem mindestens zwei Signale bestimmt werden.

7. Verfahren nach Anspruch 6, **dadurch gekennzeichnet, dass** der Quotientenverlauf durch eine Funktion interpoliert wird.

8. Verfahren nach Anspruch 7, **dadurch gekennzeichnet, dass** die Funktion aus einem Produkt aus mehreren Basisfunktionen bestimmt wird.

9. Verfahren nach Anspruch 8, **dadurch gekennzeichnet, dass** als Basisfunktionen Polynomfunktionen und Exponentialfunktionen verwendet werden.

10. Verfahren nach Anspruch 6, **dadurch gekennzeichnet, dass** der Quotientenverlauf durch ein Taylorpolynom angenähert wird.

11. Verfahren nach einem der Ansprüche 1 bis 10, **dadurch gekennzeichnet, dass** eine Temperatur des Mediums (8) bestimmt wird und die Temperatur bei der Bestimmung des Quotientenverlaufs verwendet wird.

12. Verfahren nach einem der Ansprüche 1 bis 11, **dadurch gekennzeichnet, dass** eine Spin-Spin-Relaxationszeitkonstante des Mediums (8) unter Verwendung des Quotientenverlaufs und/oder unter Verwendung des mindestens einen Signals des ersten Signalverlaufs und/oder unter Verwendung des mindestens einen Signals des zweiten Signalverlaufs bestimmt wird.

13. Kernmagnetisches Durchflussmessgerät (1) mit einem Messrohr (2), einer Magnetisierungseinrichtung (4) und einer Messeinrichtung (5), wobei das Messrohr (2) eine erste Messstrecke (6) aufweist, wobei im Betrieb ein Medium (8) durch das Messrohr (2) strömt und die Magnetisierungseinrichtung (4) das Medium (8) im Messrohr (2) magnetisiert,
**dadurch gekennzeichnet,**
**dass** die Messeinrichtung (5) ausgebildet ist, im Betrieb
- ein mit einer ersten Geschwindigkeit strömendes erstes Volumen (10) des magnetisierten Mediums (8) innerhalb der ersten Messstrecke (6) zu kernmagnetischen Resonanzen anzuregen und einen ersten Signalverlauf zu bilden, indem die Messeinrichtung (5) mindestens ein die kernmagnetischen Resonanzen des Mediums (8) im ersten Volumen (10) innerhalb der ersten Messstrecke (6) charakterisierendes Signal bestimmt,
- anschließend ein mit einer zweiten Geschwindigkeit strömendes zweites Volumen (11) des magnetisierten Mediums (8) innerhalb der ersten Messstrecke (6) zu kernmagnetischen Resonanzen anzuregen und einen zweiten Signalverlauf zu bilden, indem die Messeinrichtung (5) mindestens ein die kernmagnetischen Resonanzen des Mediums (8) im zweiten Volumen (11) innerhalb der ersten Messstrecke (6) charakterisierendes Signal bestimmt,
- einen Quotientenverlauf zu bestimmen, indem die Messeinrichtung (5) jeweils einen Quotienten aus dem mindestens einen Signal des ersten Signalverlaufs und aus dem mindestens einen Signal des zweiten Signalverlaufs bestimmt und
- die erste Geschwindigkeit und/oder die zweite Geschwindigkeit unter Verwendung des Quotientenverlaufs zu bestimmen.

14. Kernmagnetisches Durchflussmessgerät (1) mit einem Messrohr (2), einer Magnetisierungseinrichtung (4) und einer Messeinrichtung (5), wobei das Messrohr (2) eine erste Messstrecke (6) und eine zweite Messstrecke (7) aufweist, wobei im Betrieb ein Medium (8) durch das Messrohr (2) strömt und die Magnetisierungseinrichtung (4) das Medium (8) im Messrohr (2) magnetisiert,
**dadurch gekennzeichnet,**
**dass** die Messeinrichtung (5) ausgebildet ist, im Betrieb
- ein erstes Volumen (10) des magnetisierten Mediums (8) innerhalb der ersten Messstrecke (6) zu kernmagnetischen Resonanzen anzuregen und einen ersten Signalverlauf zu bilden, indem die Messeinrichtung (5) mindestens ein die kernmagnetischen Resonanzen des Mediums (8) im ersten Volumen (10) innerhalb der ersten Messstrecke (6) charakterisierendes Signal bestimmt,
- ein zweites Volumen (11) des magnetisierten Mediums (8) innerhalb der zweiten Messstrecke (7) zu kernmagnetischen Resonanzen anzuregen und einen zweiten Signalverlauf zu bilden, indem die Messeinrichtung (5) mindestens ein die kernmagnetischen Resonanzen des Mediums (8) im zweiten Volumen (11) innerhalb der zweiten Messstrecke (7) charakterisierendes Signal bestimmt,
- einen Quotientenverlauf zu bestimmen, indem die Messeinrichtung (5) jeweils einen Quotienten aus dem mindestens einen Signal des ersten Signalverlaufs und aus dem mindestens einen Signal des zweiten Signalverlaufs bestimmt und
- eine Geschwindigkeit des Mediums (8) unter Verwendung des Quotientenverlaufs zu bestimmen.

15. Kernmagnetisches Durchflussmessgerät (1) nach Anspruch 13 oder 14, **dadurch gekennzeichnet, dass** die Messeinrichtung (5) zum Ausführen eines Verfahrens nach einem der Ansprüche 3 bis 12 ausgebildet ist.
